(19) Europäisches Patentamt

European Patent Office

Office européen des brevets

(11) Publication number: **0 305 993**
**A2**

## EUROPEAN PATENT APPLICATION

(21) Application number: 88114193.1

(51) Int. Cl.⁴: **H01L 23/48**

(22) Date of filing: 31.08.88

(30) Priority: 31.08.87 JP 217263/87

(43) Date of publication of application:
08.03.89 Bulletin 89/10

(84) Designated Contracting States:
DE FR GB

(71) Applicant: **KABUSHIKI KAISHA TOSHIBA**
**72, Horikawa-cho Saiwai-ku**
**Kawasaki-shi Kanagawa-ken 210(JP)**

(72) Inventor: **Imamura, Kaoru c/o Patent Division**
**Kabushiki Kaisha Toshiba 1-1 Shibaura**
**1-chome**
**Minato-ku Tokyo 105(JP)**

(74) Representative: **Lehn, Werner, Dipl.-Ing. et al**
**Hoffmann, Eitle & Partner Patentanwälte**
**Arabellastrasse 4**
**D-8000 München 81(DE)**

(54) Power semiconductor device having electrode structures.

(57) A bonding pad (21a) for the main current electrode is formed to have a large area on a semiconductor chip (20). An emitter lead (24) serving as a main current external electrode structure having a large current capacity is soldered to the entire surface of the bonding pad (21a). With this construction, even if a large current flows when the load is short-circuited, for example, arc discharge due to cut-off of the current path will not occur, and therefore there is no possibility that the semiconductor device will explode.

F I G. 4A

## Semiconductor device

This invention relates to a power semiconductor device having a control electrode, and more particularly to a semiconductor device having a main current extraction structure to restrict damage to a limited area even when a short circuiting of a load such as a motor occurs, for example, when a power transistor is used for motor driving.

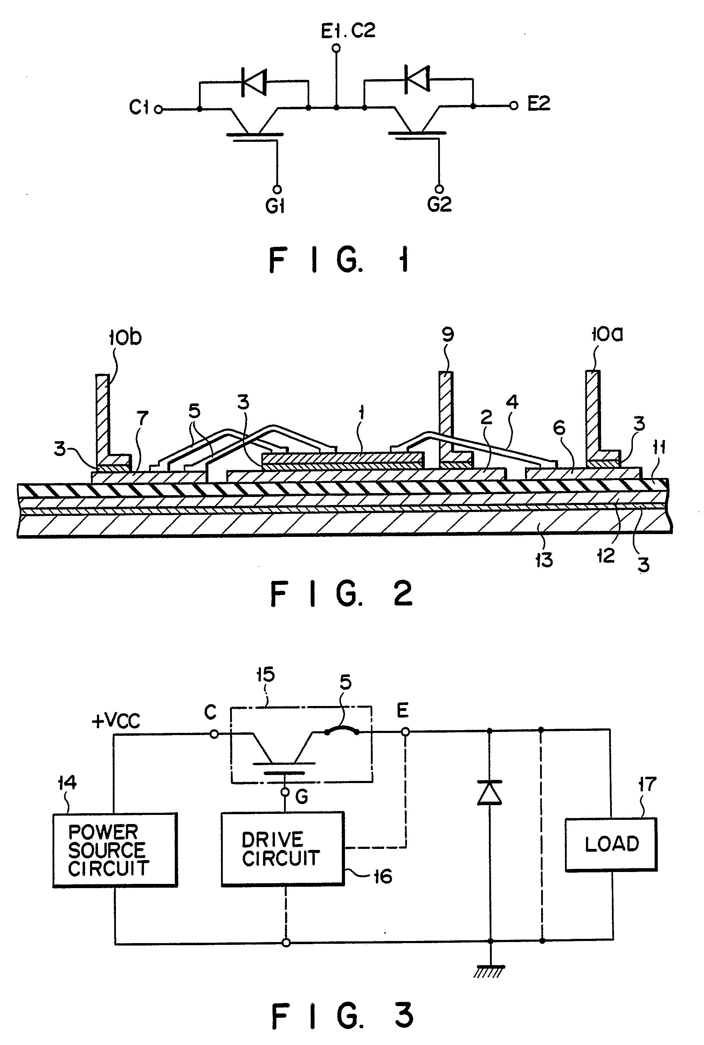

First, a motor driving power transistor is explained as the prior art typical power semiconductor device (transistor, thyristor and the like) having a control electrode. In general, the motor driving power transistor is mainly formed of, so-called 2-in-1 or 6-in-1 type module structure in which two or six power elements are modularized in a single outer casing. Fig. 1 shows the circuit construction of a semiconductor device of 2-in-1 type module using an insulated gate bipolar transistor (IGBT) as a power element. Fig. 2 is a cross section showing the basic structure of one power element of the semiconductor device. Transistor chip 1 is bonded to collector electrode connection copper plate 2 with solder 3. Portions of the upper surface of the chip are connected to base electrode connection copper plate 6 and emitter electrode connection copper plate 7 by means of base bonding aluminum wire 4 and emitter bonding aluminum wires 5, respectively. Collector external electrode lead 9, base external electrode lead 10a and emitter external electrode lead 10b are respectively bonded to electrode connection copper plates 2, 6 and 7 by soldering. Electrode connection copper plates 2, 6 and 7 are patterned to be separated from one another and fixedly formed on ceramic base plate 11. Copper plate 12 is fixed on the rear surface of ceramic base plate 11 and mounted on heat radiation plate 13 with solder 3. After this, parts described above are set into an outer casing and then resin-packaged, although not shown in Fig. 2.

When the semiconductor device is used for motor driving, the load may be short-circuited by the damage or deterioration of the motor or other cases, and a large short circuit current will flow through the device. In a case where an aluminum wire is used for connection to the emitter electrode as in the described semiconductor device, the module outer casing may be exploded with impulsive second when the load is short-circuited, and consequently expensive driving circuits mounted around the casing may be damaged.

As described above, when the power semiconductor device is used for motor driving or the like, not only the semiconductor device but also various circuits connected thereto may be damaged in a case of short-circuited of the load.

Now, the short-circuited mechanism is explained in a case where an IGBT formed in a semiconductor chip is used. Fig. 3 is a diagram showing the construction of a non-reciprocal chopper circuit for supplying electric power to load (D.C. motor, for example) 17 by means of power source circuit 14, IGBT 15 and drive circuit 16. In Fig. 3, Vcc denotes a high voltage of the power source line, 5 denotes an emitter bonding aluminum wire of the transistor 15, and C, E and G denote collector, emitter and gate terminals, respectively. Drive circuit 16 is connected to the gate terminal and emitter terminal or ground terminal as shown by broken lines.

In a case where load 17 is short-circuited (as shown by broken lines in Fig. 3) for some abnormal causes, (a) high voltage Vcc of the power source line is directly applied between the collector and emitter terminals C and E of IGBT 15. (b) As a result, a short-circuit current several times larger than the rated current flows into the element 15, damaging the chip 15 to short-circuit a path between the collector and emitter terminals C and E. (c) The short-circuit current in the chip 15 further rapidly increases because of the short-circuit between the collector and emitter terminals C and E, sequentially melting a plurality of emitter bonding aluminum wires 5 which are bonded to the chip 15. (d) When the last emitter aluminum wire is melted or cut off, an arc discharge occurs between the this last melted wire and chip 15, causing the module to explode. (e) After all the emitter wires are cut off, the emitter potential of the chip is set into an electrically floating state with respect to the ground potential, and power source voltage Vcc is applied between the gate and collector terminals G and C. (f) A gate insulation film may be easily damaged by power source line voltage Vcc, causing a path between the gate and collector terminals G and C to be short-circuited. (g) As a result, high voltage Vcc of the power source line will be directly applied to the output terminal of drive circuit 16, thus damaging the drive circuit 16.

In order to prevent generation of sequential accidents including damage of various circuits such as the drive circuit 16 and explosion of the module of the chip 15 due to the short-circuit of the load 17 as described above, a fuse may be connected between the power source 14 and the module 15 so as to interrupt the short-circuit current by blowing the fuse before the emitter bonding aluminum wire is melted. However, in this case, it is necessary to set the fuse blowing current relatively smaller than the maximum rated current of the power transistor in order to ensure the stable and steady operation. In other words, it is necessary to increase the number of power transistors used in order to reduce the steady operation current.

Further, a pressure-contact structure used in thyristors is known as the explosion-proof type main current extraction structure. However, in a case where the module of 2-in-1, 4-in-1 or 6-in-1 type circuit configuration is formed with the pressure-contact structure, the dimensions of the other casing are increased, parts are made complex, the cost thereof increases and the value of the product is significantly lowered. The number of aluminum wires may be increased to prevent the melting and cut-off of the aluminum wires. However, in this case, it becomes difficult to form the module with complicated circuit construction.

An object of this invention is to provide an explosion-proof type semiconductor device with a control electrode in which, even when a short circuiting of a load occurs, various circuits such as the drive circuit connected thereto can be prevented from being damaged to suppress occurrence of explosion accident or the like, and which can be easily formed into a desired module form.

A semiconductor device according to this invention uses a main current external electrode structure without using bonding wires to supply a main current from the electrode of the semiconductor chip to the external load.

That is, the semiconductor device of this invention includes a semiconductor chip having bonding pads for main current and control electrodes formed on the chip main surface; a main current external electrode structure directly fixed on the bonding pad of the main current electrode; and a control external electrode structure connected to the bonding pad of the control electrode via a bonding wire.

The main current electrodes has a portion to be made in ohmic contact with the base plate, a bonding pad portion to be connected to the external electrode, and a wiring portion. The main current external electrode structure (for example, emitter lead) has a conductive cross sectional form so as to not be melted by a short-circuit current. For example, it is formed of plate-like or rod-like conductive material in a single-electrode form or assembled electrode form. The main current external electrode structure is fixed at one on the bonding pad and the other end thereof is formed to extend out of the outer casing.

In the semiconductor device described above, since the main current circuit (for example, emitter lead) will not be melted even in the short-circuit of the load, the potential of the semiconductor chip is significantly lowered by a voltage drop due to the short-circuit current in the internal resistive component of the power source or the like in comparison with the potential in the normal operation mode.

Therefore, a high power source voltage will not be applied to associated circuits such as a drive circuit connected to the semiconductor device, effectively preventing them from being damaged. Further, the conductor will not be melted, and arc discharge will not occur, preventing occurrence of explosion accident. Thus, an explosion-proof type semiconductor device can be attained.

In a preferred embodiment, for example, the semiconductor device is formed to have an insulated gate structure (MOS structure) in which a necessary control power is extremely small, an area of the bonding pad of the main current electrode is made larger than that of the bonding pad of the control electrode, and a pad surface layer is formed of metal suitable for the bonding method used. Therefore, as will be described later, it is preferable to form the main current and control electrodes so as to have the laminated structure and connected with a multi-layered wiring structure.

This invention can be more fully understood from the following detailed description when taken in conjunction with the accompanying drawings, in which:

Fig. 1 is a circuit diagram showing the circuit construction of a semiconductor device of 2-in-1 type module using an IGBT;

Fig. 2 is a cross sectional view of a basic structure of a conventional semiconductor device;

Fig. 3 is a circuit diagram of an application example for illustrating problems occurring in the conventional semiconductor device;

Fig. 4A is a schematic front view including part of the cross section of a semiconductor device according to one embodiment of this invention;

Fig. 4B is a plan view of the semiconductor device shown in Fig. 4A; and

Fig. 5 is a schematic cross sectional view of a semiconductor pellet used in the semiconductor device of Figs. 4A and 4B.

There will now be described an embodiment of this invention with reference to the accompanying drawings.

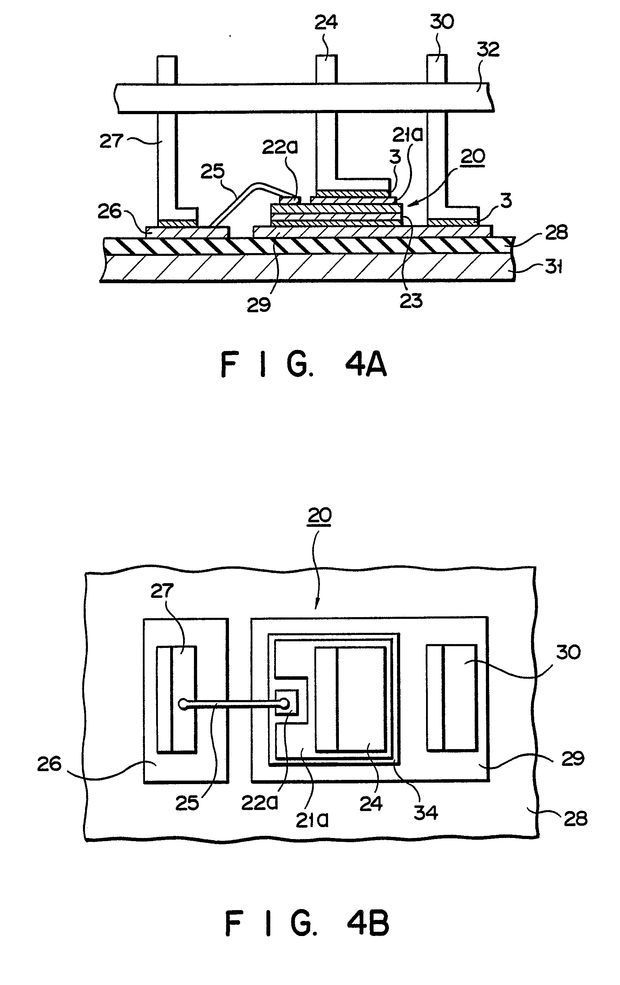

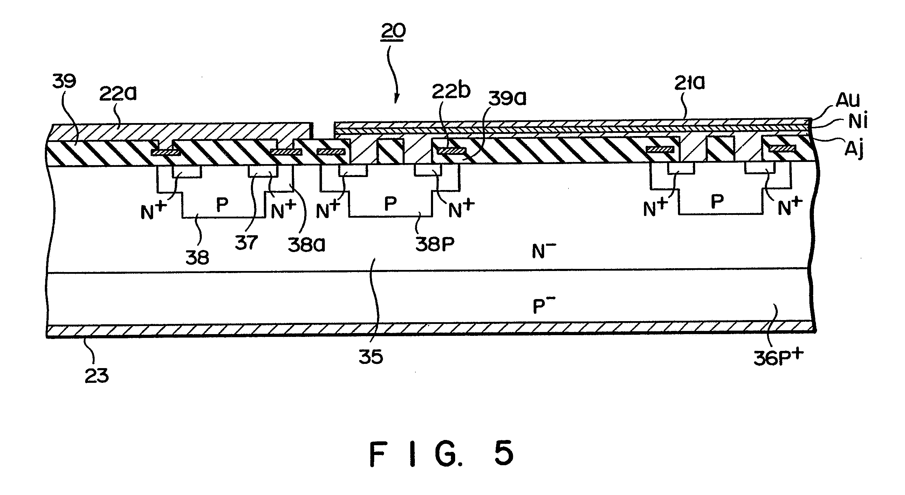

First, an example of a basic structure using an IGBT is explained with reference to the schematic diagrams. Fig. 4A is a schematic front view including part of the cross section of a semiconductor device according to one embodiment of this invention, Fig. 4B is a plan view of the semiconductor device shown in Fig. 4A from which an outer casing (including sealing resin) is omitted, and Fig. 5 is a cross sectional view of an IGBT chip. As shown in Fig. 4A, bonding pad 21a which is part of the main current electrode (emitter electrode), bonding pad 22a which is part of the control gate (gate electrode) and main current electrode (collector electrode) 23 are formed on the main surface of IGBT chip 20. Main current external electrode structure (emitter lead) 24 is directly bonded to emitter bonding pad 21a with solder 3. Further, control external structure (gate electrode connection copper plate) 26 and control electrode structure (gate lead) 27 are connected to gate bonding pad 22a via bonding wire 25. Gate electrode connection copper plate 26 and main current external electrode structure (collector electrode connection copper plate) 29 are fixedly separately formed on one of the main surfaces of ceramic plate 28. Collector electrode 23 is soldered to copper plate 29. In a case where the transistor module is formed to include a plurality of transistors, the electrode connection copper plate is patterned on the ceramic plate 28 so as to meet the circuit construction of the transistor module. Heat radiation plate 31 is fixed on the rear surface of ceramic plate 28. Gate lead 27, emitter lead 24 and collector lead 30 are combined by holder 32 (which is formed of resin and also used as part of the outer casing), soldered to respective pads and then the internal portion thereof is resin-sealed.

Next, the basic structure of N-channel type IGBT chip 20 is explained with reference to Fig. 5. The structure is obtained by forming $P^+$-type collector region 36 in contact with $N^-$-type drain region 35 of a vertical insulated gate field effect transistor, and is called an IGBT or a conductivity modulated type MOSFET. Portion of P-type body 38 which is exposed to the substrate surface and disposed between $N^+$-type source region 37 and $N^-$-type drain region 35 is used as N-channel formation region 38a of the MOSFET. Gate electrode 22b of polysilicon is formed to face channel formation region 38a with gate oxidation film 39a disposed therebetween. The main surface of the chip is protected by interlayer oxidation film ($SiO_2$) 39, and emitter and gate bonding pads 21a and 22a are formed on oxidation film 39.

Now, the electrode arrangement of the IGBT chip is explained with reference to Figs. 4B and 5. First, polysilicon gate electrode 22b and multi-layered wiring layers are formed, and then gate bonding pad 22a is formed in an outlying area of chip 20. In a case where the chip size is increased, it is desirable to take the area occupied by the gate resistor in the chip into consideration and arrange pads 22a in suitable positions of the outlying area of the chip. The remaining portion of the chip area except gate bonding pad 22a and withstanding voltage designing area 34 of the chip outlying area is used as emitter bonding pad 21a. Gate bonding pad 22a is formed of aluminum and emitter bonding pad 21a is formed of laminated structure of Au-Ni-Aℓ in order to be securely bonded to emitter lead 24 with solder. No particular advantage can be obtained even if gate bonding pad 22a is bonded in the same soldering condition as that of emitter bonding pad 21a. That is, the current capacity of the gate electrode is smalled in the IGBT, and therefore it is advantageous that the bonding pad area can be reduced if aluminum bonding is used only for the gate.

As described above, in the semiconductor device of this invention, it is important that the main current external electrode structure (emitter lead in the above embodiment) is not melted or cut-off even when the load connected in series with the device is short-circuited. That is, it is important that the emitter lead is formed to have a cross section (perpendicular to the current flow direction) of a predetermined configuration so as not to be melted by the short-circuit current. For this purpose, it is preferable to form the emitter lead in the rod-like or plate-like form. The main current electrode and control electrode having the bonding pads are formed at least partially in the form of laminated structure by different conductive materials, and the surface layer of the bonding pad is formed of metal respectively suitable for bonding methods such as soldering and heat-bonding methods. In the former embodiment, since the emitter lead is directly soldered to the bonding pad, the surface layer of the bonding pad is preferably formed of gold. In contrast, since the gate lead is bonded to the gate bonding pad via the aluminum bonding wire, the surface layer of the bonding pad is preferably formed of aluminum. Further, in order to prevent the emitter lead from being melted by the short-circuit current, the emitter bonding pad is formed to have an area larger than that of the gate bonding pad. For this purpose, it is preferable to form the emitter electrode and gate electrode in the form of multi-layered structure, and polysilicon gate electrode 22b and the emitter bonding pad 21a are formed in the form of multi-layered structure with interlayer oxide film 39 disposed therebetween. Further, in the embodiment, part of polysilicon gate electrode 22b and the gate bonding pad 22a are formed in the form of multi-layered structure. In the MOSFET, IGBT or the like having the insulated gate structure (so-called MOS structure formed on an electrode, oxide film and semiconductor layer) in which necessary control power is small, the area of the gate bonding pad can be reduced. Therefore, this invention can be preferably applied to these semiconductor devices.

As described above, unlike the conventional semiconductor device in the main current electrode (for example, the emitter electrode) is extracted via the bonding wire, the bonding pad for the main current electrode is formed to have an area large as possible on the semiconductor chip in this invention and the main current electrode is extracted via the main current external electrode structure (emitter lead) which has a large current capacity and is, for example, uniformly soldered to the entire surface of the bonding pad for the main current electrode.

Therefore, in the semiconductor device of this invention, even when the load is short-circuited the main current electrode structure and the pad on the chip will not be cut off.

As described above, according to this invention, an explosion-proof type semiconductor device can be provided in which the circuit such as the drive circuit connected to the chip can be effectively prevented from being damaged. Further, since no arc discharge occurs, the semiconductor device (including the module) will not be exploded. In addition, the main current external electrode structure is directly fixed on the chip, the module of complicated circuit construction can be easily obtained.

## Claims

1. A semiconductor device characterized by comprising:
a semiconductor chip (20) having bonding pads formed on a chip main surface as parts of main current and control electrodes;
a main current external electrode structure (24, 30) directly fixed on said bonding pad (21a) of said main current electrode; and
a control external electrode structure (26, 27) connected to said bonding pad (22a) of said control electrode via a bonding wire.

2. A semiconductor device according to claim 1, characterized in that said main current external electrode structure (24, 30) is formed in a rod-like or plate-like form.

3. A semiconductor device according to claim 1, characterized in that said main current and control electrodes (21a, 22a) are formed of different conductive materials and in the form of laminated structure.

4. A semiconductor device according to claim 3, characterized in that said main current external electrode structure (24, 30) is directly bonded to said bonding pad (21a) of said main current electrode by soldering (3), and a surface layer of said bonding pad (21a) is formed of gold.

5. A semiconductor device according to claim 1, characterized in that a surface layer of said bonding pad (22a) of said control electrode is formed of aluminum.

6. A semiconductor device according to claim 1, characterized in that said semiconductor chip (20) is formed to have an insulated gate structure (22b, 39a).

7. A semiconductor device according to claim 1, characterized in that said main current and control electrodes (21a, 22a) are respectively formed with the multi-layered wiring structure.

E1. C2

C1

G1

G2

E2

# F I G. 1

10b

9

10a

7

5

3

1

2

4

3

3

6

11

13

12

3

# F I G. 2

15

5

+VCC

C

E

14

POWER
SOURCE
CIRCUIT

DRIVE
CIRCUIT

G

16

17

LOAD

# F I G. 3

F I G. 4A

F I G. 4B

F I G. 5

EP 0 305 993 A2